# EUROPEAN PATENT APPLICATION

(11) **EP 4 387 403 A1**
(43) Date of publication of application: **19.06.2024**
(21) Application number: 22213417.3
(22) Date of filing: 14.12.2022
(51) Int. Cl.: H05K 3/30, H05K 3/34

(54) **SOLDERING A SURFACE MOUNT DEVICE TO AN APPLICATION BOARD**

(71) Applicant: Infineon Technologies Austria AG, 9500 Villach (AT)
(72) Inventor: WONG, Jek Hoe, 75150 Bukit Baru (MY); RICK, Michael, 93128 Regenstauf (DE)
(74) Representative: Lambsdorff & Lange Patentanwälte Partnerschaft mbB

(57) **Abstract**

A method of soldering a surface mount device (SMD) to an application board comprises depositing one or more first adhesive volumes onto the application board. The one or more first adhesive volumes are hardened. One or more second adhesive volumes are deposited onto the application board. The SMD is placed on the hardened one or more first adhesive volumes in contact with the one or more second adhesive volumes, wherein the SMD is supported by the hardened one or more first adhesive volumes to form a gap between the application board and the SMD. The one or more second adhesive volumes are hardened to hold the SMD to the application board. The SMD is soldered to the application board by applying molten solder in the gap between the application board and the SMD.

## Description

### Technical Field

This disclosure relates generally to techniques of attaching an electronic device to an application board, and in particular to soldering a surface mount device to an application board.

### Background

Surface mount devices (SMDs) are widely used in electronic circuits. A standard mount-on-board method for SMDs is reflow soldering. Reflow soldering allows good solder joints to be obtained between exposed pads on the bottom of the device package and the application board.

Wave soldering is another known mount-on-board technique. Wave soldering is cheaper, less time consuming and more attractive for mass production than reflow soldering. However, wave soldering is primarily a method for mounting through-hole devices on the application board, but is hardly able to produce good solder joints for SMDs, especially non-leaded SMDs.

### Summary

According to an aspect of the disclosure, a method of soldering a SMD to an application board comprises depositing one or more first adhesive volumes onto the application board. The one or more first adhesive volumes are hardened. One or more second adhesive volumes are deposited onto the application board. The SMD is placed on the hardened one or more first adhesive volumes in contact with the one or more second adhesive volumes, wherein the SMD is supported by the hardened one or more first adhesive volumes to form a gap between the application board and the SMD. The one or more second adhesive volumes are hardened to hold the SMD to the application board. The SMD is soldered to the application board by applying molten solder in the gap between the application board and the SMD.

According to an aspect of the disclosure, a system comprises a SMD and an application board to which the SMD is mounted. The system further comprises one or more posts of hardened adhesive arranged between the application board and the SMD, wherein a gap is provide between the application board and the SMD. A solder bond is arranged at least partly within the gap between the application board and the SMD, wherein the gap has a height of equal to or greater than 150 or 200 µm.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a flowchart illustrating exemplary stages of a method of soldering a SMD to an application board.
Figure 2 is a side view of an example of a system comprising a SMD soldered to an application board.
Figure 3 illustrates first adhesive volumes deposited on an application board.
Figure 4 illustrates second adhesive volumes deposited on the application board of Figure 3.
Figures 5A-5D are perspective top and footprint views of exemplary SMDs suited for application board assembly in accordance with the disclosure.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

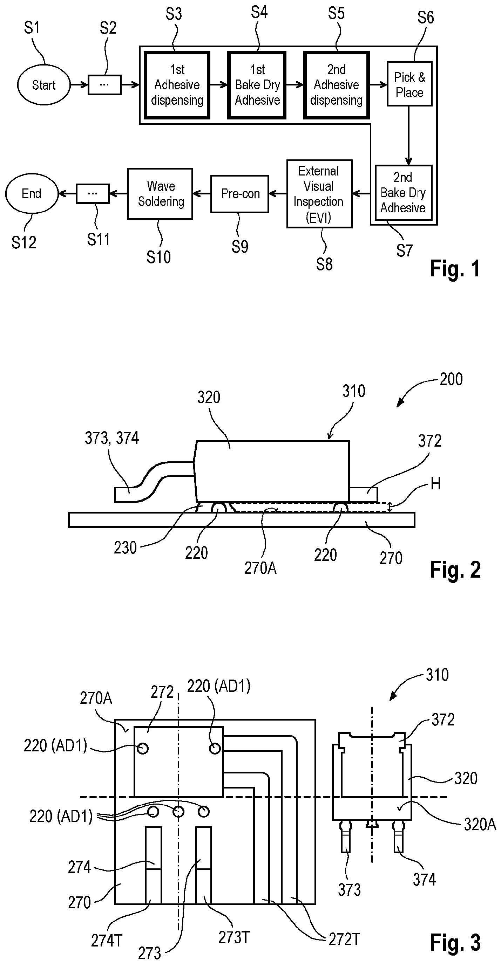

Referring to Figures 1 and 2, a process of soldering a SMD 310 to an application board 270 (also referred to as substrate board in the art) starts at S1. A SMD as recited herein is a more general term for so-called surface mount components, SMCs, which are also part of this disclosure. An application board (or substrate board) may, e.g., be or comprise a printed circuit board (PCB), a ceramic-based substrate or any other substrate suited for mounting SMDs, in particular power SMSs.

At S2 usual preparatory steps such as, e.g., cleaning the application board 270, are carried out.

At S3 first adhesive volumes 220 are deposited onto the application board 270. The adhesive volumes 220 may be liquid during application.

At S4 the one or more first adhesive volumes 220 are hardened. By hardening the first adhesive volumes 220 mechanically stable posts are generated which will be used to support the SMD 310 at an adjustable height H above the application board 270, as will be described further below in more detail.

At S5 one or more second adhesive volumes 230 are deposited onto the application board 270. The one or more second adhesive volumes are intended to (firmly) hold the SMD 310 to the application board 270.

At S6 the SMD 310 is placed on the hardened one or more first adhesive volumes 220. The SMD 310 is supported by the hardened one or more first adhesive volumes 220 to form a gap of (e.g. minimal) height H between the application board 270 and the SMD 310. The hardened one or more first adhesive volumes 220 are also referred to as posts of hardened first adhesive herein. The posts (which can also be referred to as hardened adhesive dots) may have a semi-spherical shape, for example.

At S7 the one or more second adhesive volumes 230 applied at S5 are hardened to hold the SMD 310 to the application board 270.

In other words, stages S3 to S7 relate to the mount-on-board process. The SMD 310 is fixedly attached to the application board 270 by hardened adhesive (namely the second adhesive applied at stage S5). A gap is provided between the application board 270 and the SMD 310. The height H of the gap is controlled by the height of the one or more first adhesive volumes 220, which serve as spacer element(s) between the application board 270 and the SMD 310.

More specifically, referring to Figure 2, the SMD 310 may include an encapsulation body 320 having a bottom surface 320A. The height H may be measured between the bottom surface 320A of the encapsulation body 320 and an upper surface 270A of the application board 270.

Subsequently, optional stages S8 and S9 may be carried out. At S8 an external visual inspection (EVI) of the assembly comprising the application board 270 and the SMD 310 may be carried out. At S9 the assembly may be pre-conditioned, e.g., by applying cleaning steps and/or by applying flux on areas to be soldered. For example, flux may be sprayed on conductive lands on the application board 270 and/or on metallization(s) 372 exposed at a bottom surface of the SMD 310 and/or on leads 373, 374 of the SMD 310. The flux may be introduced into the gap between the application board 270 and the bottom surface of the SMD 310.

At S10 the SMD 310 is soldered to the application board 270 by applying molten solder in the gap between the application board 270 and the SMD 310. For example, the molten solder is introduced into the gap by wave soldering.

Wave soldering is a known technique for mounting through-hole devices to an application board. If wave soldering is used for mounting SMDs on application boards, solder coverage is often insufficient and/or highly unreproducible so that the process will often end up in electrical failures (scrap parts).

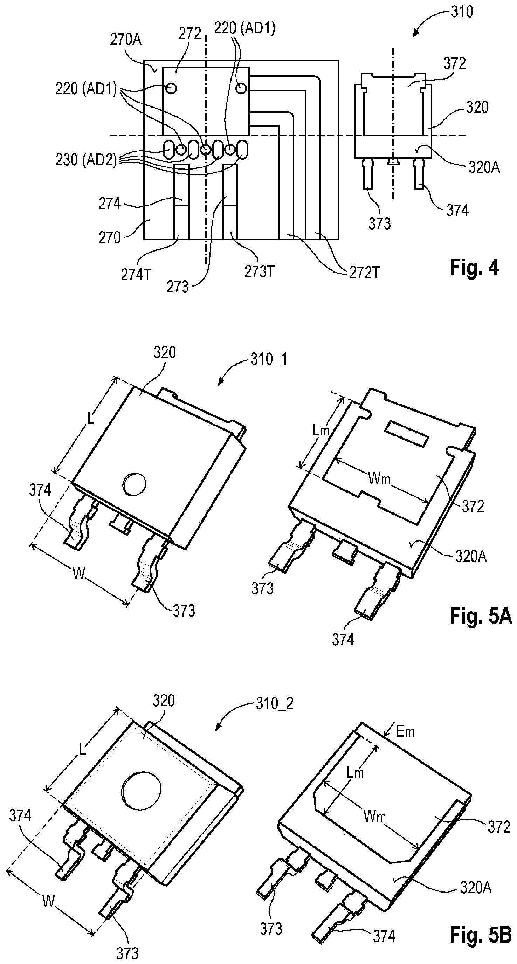

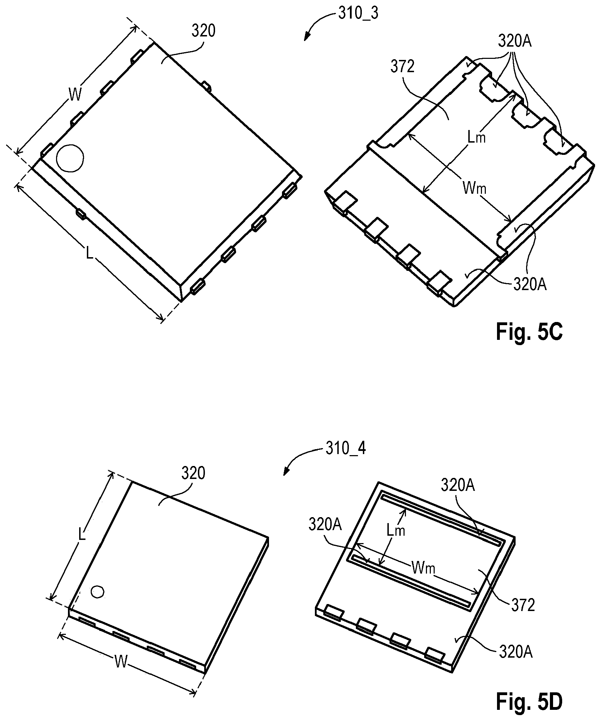

By "lifting" the SMD 310 up to a (minimum) height H above the upper surface 270A of the application board 270, it can be guaranteed that molten solder will flow into and fill up the gap between exposed metallization(s) 270 at the bottom surface of the SMD 310 and the application board 270. The height H may be equal to greater than 150 or 200 µm. For example, for large packages (e.g. SMDs 310_2 and/or 310_4, see Figures 5B, 5D) the height H may, e.g., be equal to greater than 250 or 300 µm. An upper limit for H may, e.g., be about 300 or 400 pm.

In contrast, standard mount-on-board processes are using only one adhesive dispensing process (i.e. are not using S3 and S4). A single adhesive dispensing process typically provides a gap of about H ≈ 60 µm in the hardened state, which is too small to allow molten solder flowing into it.

For example, S3 and/or S5 may be carried out by dispensing the first adhesive volume(s) 220 and/or the second adhesive volume(s) 230 onto the application board 270. For example, the same adhesive dispensing equipment (not shown) may be used for these two dispensing processes. Hence, in this case, no investment of new equipment is required for the "double-dispensing process" as described herein.

Further, depositing the first and/or second adhesive volume(s) 220, 230 by dispensing allows to obtain a high degree of process control for the subsequent soldering method. For example, the dispensing processes can be control by appropriately choosing the number and/or positions and/or quantities of adhesive for each of the one or more first and/or second adhesive volumes 220 and 230.

For example, the first adhesive volumes 220 may be positioned onto the application board 270 at locations corresponding to at least four corners of the SMD 310. This provides proper support and balancing of the SMD 310. Further, the gap can be controlled to have a substantially constant height H across its entire extension. In all cases a minimum height H can be set. Further, thermal considerations can be taken into account, as will be described further below.

The quantity of adhesive to form the first adhesive volumes 220 and/or the second adhesive volumes 230 may be controlled via the dispenser's nozzle size and the dispensing time. For example, appropriate first adhesive volumes 220 may be generated by using a dispenser's nozzle size diameter of about 0.4 mm and a dispensing time of about 130 ms per applied first adhesive volume 220.

At least for the first adhesive, a high viscosity type adhesive may be used. For example, the viscosity of the adhesive may be equal to or greater than 250 or 300 Pa × s.

Hardening at S4 may be performed by a so-called bake dry process. The height of the first adhesive volume(s) 220 may increase by baking (hardening). For example, a liquid first adhesive volume 220 of about 50 µm height may increase in height to a dried (hardened) first adhesive volume 220 of about 125 µm in height. The height H of the gap is set by the height of the dried (hardened) first adhesive volumes 220.

Hardening (also referred to as drying, baking or curing) of the liquid first adhesive volume(s) 220 may be carried out at elevated temperature for a specific period of time. For instance, a temperature of about 125°C and a curing time (hardening time) of 1 hour may be used. Higher temperatures are possible since the SMD 310 is not yet mounted at that time.

Depositing the one or more second adhesive volumes 220 on the application board 270 may be carried out at S5 after hardening the one or more first adhesive volumes 220 at S4. The second adhesive volume(s) 230 are used to firmly hold the SMD 310 on the application board 270. Analogously, as described above for dispensing the first adhesive volume(s) 220, the process of dispensing the second adhesive volume(s) 230 may be controlled to appropriately adjust quantities and positions of the second adhesive volumes 230 on the application board 270.

For example, the deposition of the second adhesive volume(s) 230 may be carried out by using a dispenser having a nozzle size of a diameter of about 0.4 mm. The volume or quantity of the second adhesive can be controlled with the dispensing time. For example, the dispensing time may, e.g., be set to about 130 ms per applied second adhesive volume 230.

The quantity of adhesive used for the second adhesive volumes 230 may vary depending on the SMD type. The quantity should be set to ensure sufficient holding strength during subsequent soldering of the SMD 310 by, e.g., wave soldering.

The first and second adhesive materials and/or the dispensing equipment to deposit the first and second adhesive volumes 220, 230 may be the same.

The second adhesive volume(s) 230 may be hardened (at S7) in the same way as described before with reference to S4.

For example, the at least one or more second adhesive volumes 230 may be deposited onto the application board 270 at locations which are in average nearer to the center of the SMD 310 than the locations at which the first adhesive volumes 220 have been deposited. This condition may, e.g., be met if the mean distance of the (liquid or hardened) first adhesive volumes 220 from the center of the SMD 310 is larger than the mean distance of the (liquid or hardened) second adhesive volumes 230 from the center of the SMD 310.

Further, locations at which the one or more first adhesive volumes 220 are deposited and locations at which the one or more second adhesive volumes 230 are deposited may, e.g., be selected such that they are offset from each other. This condition may (already) be met if the center of the nozzle(s) for dispensing the first adhesive volume(s) 220 and the second adhesive volume(s) 230 are not aligned, i.e. are intentionally spaced apart from each other. For example, if a number of first adhesive volumes 220 are dispensed in a row, second adhesive volumes 230 may, e.g., be dispensed in the spacing between adjacent first adhesive volumes 220.

In particular, the locations at which the one or more first adhesive volumes 220 are deposited and locations at which the one or more second adhesive volumes 230 are deposited may, e.g., be selected such that they do not overlap. This condition may be met if the hardened first adhesive volume(s) 220 and the liquid or hardened second adhesive volume(s) 230 are separate from each other, i.e. are substantially not in contact with each other. In this case, the center of the nozzle(s) for dispensing the first adhesive volume(s) 220 and the second adhesive volume(s) 230 may, e.g., be spaced apart from each other by a distance which is greater than the diameter of the posts of the hardened first adhesive volumes 220.

While in some examples first adhesive volumes 220 and second adhesive volumes 230 in the hardened state may be separate from each other, in other examples at least some of the first adhesive volumes 220 and the second adhesive volumes 230 may partly connect to each other in the hardened state. Nevertheless, their dispensing locations or center positions (e.g. the dispenser's nozzle positions) may, e.g., be offset from each other.

Returning to Figure 1, at S10 a system 200 including the SMD 310 and the application board 270 is assembled (Figure 2). Subsequently, at S11 visual and/or X-ray inspection of the solder bonds (solder joints) may, e.g., be carried out. In particular, the degree of solder coverage of the package terminals (metallization 372 and/or leads 372, 374) and/or the application board lands may be determined. Further, functional testing may be performed, for example.

The process of soldering a SMD 310 to an application board 270 to obtain a system 200 ends at S12.

Figure 3 illustrates possible locations AD1 at which first adhesive volumes 220 may be deposited on the upper surface 270A of the application board 270. At least one conductive land 272 is provided on the upper surface 270A of the application board 270. Further conductive lands 273, 274 may be provided in the vicinity of conductive land 272. The conductive lands 272, 273, 274 may, e.g., be insular, i.e. not connected to each other. The conductive lands 272, 273, 274 are electrical terminals of the application board 270, which are to be connected with corresponding terminals of a SMD 310. Therefore, the locations and/or shapes of the conductive lands 272, 273, 274 on the application board 270 correspond to the locations and/or shapes of the terminals of the SMD 310 to be mounted on the application board 270.

The conductive lands 272, 273, 274 on the application board 270 are, however, typically larger in size than the metallization 372 and the leads 373, 374, respectively, of the SMD 310. That way, the solder connections between the conductive lands 272, 273, 274 and the corresponding metallization 372 and leads 373, 374 of the SMD 310 are improved.

The application board 270 may further comprise conductive traces 272T, 273T, 274T connected to corresponding conductive lands 272, 273 and 274, respectively.

At least one conductive land (here conductive land 272) may be a conductive land which is intended to be connected to a bottom surface metallization of the SMD 210.

The right part of Figure 3 illustrates the footprint of a SMD 310, which is to be mounted on the application board 270. At least one metallization 372 is exposed at the bottom surface of the SMD 310, e.g. adjacent to the bottom surface 320A of the encapsulation body 320 (which may, e.g., be flush with the exposed surface of the bottom metallization 372). The bottom metallization 372 forms an electrical terminal of the SMD 310. For example, the bottom metallization 372 may be connected to a load current electrode of a power transistor (not shown) accommodated in the encapsulation body 320.

As will be described further below by way of several examples, the bottom metallization 372 may, e.g., have an area which is equal to or greater than 30%, 40%, 50%, 60%, 80% or 90% of the footprint area of the SMD 310. In particular, the area of the bottom metallization 372 may be equal to or greater than 1.0, 1.5, 2.0 or 2.5 times the area of the bottom surface 320A of the encapsulation body.

The SMD 310 may (optionally) further include leads 373, 374. As shown in Figure 2, the leads 373, 374 protrude from a side face of the encapsulation body 320. The leads 373, 374 are to be soldered to the conductive lands 273 and 274, respectively.

As apparent from Figure 3, the locations AD1 at which the first adhesive volumes 220 are deposited may be chosen such that the (hardened) first adhesive volumes 220 make contact to the bottom surface 320A of the encapsulation body 320, but not to the bottom metallization 372 of the SMD 310. Further, as mentioned above, the locations of the first adhesive volumes 220 may be chosen such that they provide for a positionally stable support for the SMD 310. In particular, at least four first adhesive volumes 320 may be positioned near corners of the SMD 310, i.e. corners of the encapsulation body 320, for example.

Figure 4 illustrates locations AD2 at which the second adhesive volumes 230 may be deposited on the application board 270. As shown in Figure 4 by way of example, the locations AD1 at which the first adhesive volumes 220 are deposited on the application board 270 do not overlap with the locations AD2 at which the second adhesive volumes 230 are deposited.

For example, the second adhesive volumes 230 have been dispensed by a two head dispenser creating two second adhesive volumes 230 ("dots") at a time. Therefore the second adhesive volumes 230 are, in this example, shaped oval. This may allow more second adhesive to be deposited in a given space between two (hardened) first adhesive volumes 220.

The diameter of the posts of the hardened first adhesive volumes 220 may, e.g., be about 1.0 to 1.2 mm, for example. The distance between the centers of the hardened first adhesive volumes 220 in the lower row may, e.g., be about 3.25 mm. In this and other examples, there is sufficient space between adjacent posts of the hardened first adhesive volumes 220 to place the second adhesive volume(s) 230 therebetween. All of the above dimensional data are exemplary values that are adjustable within limits of, for example, ±50% or ±30% or ±10% depending on the SMD to be elevated. In particular, the values may depend on the package footprint geometry and/or on the height H of the gap.

Further, the locations AD1, AD2 should be chosen such that no blocking of molten solder flowing into the gap underneath the SMD 310 during soldering is experienced. In this regard, the layout of the conductive lands 272, 273, 274, the locations AD1, AD2 of the first and second adhesive volumes 220, 230, respectively, and the direction of the solder wave during wave soldering should be chosen to not impede the fill-up of the gap with molten solder.

For a good solder bond between the bottom metallization 372 and the conductive lands 272, at least the majority of the overlapping area of these elements should be filled by solder. Experiments using a specific package (namely PG-TDSON-8-7 of Infineon^{®} as shown in Figure 5C) revealed that, if a gap of H = 200 µm between the SMD 310 and the application board 270 was used, quality assessment after current IPC-norm was satisfied and/or at least 75% of the total area was covered (i.e. filled-up) with solder. If a gap of only H = 120 µm was used with this package, only about 50% of the systems obtained were good samples, while the residual part did not meet the requirements in view of electrical and/or thermal contact between the conductive lands 272 and the metallization 372.

Figures 5A-5D illustrate exemplary SMDs 310_1, 310_2, 310_3 and 310_4, respectively, which are suited for board assembly in accordance with the disclosure. All SMDs 310_1 to 310_4 are packaged power SMDs (also known as surface mount devices (SMDs) in the art). While SMD 310_1 and SMD 310_2 are leaded devices (packages), SMD 310_3 and SMD 310_4 are leadless devices.

The SMD 310_1 is a conventional transistor package of Infineon^{®} referred to as PG-TO252-3-11. Figures 2 to 4 are illustrations using a SMD 310 of package type PG-TO252-3-35, which is similar to SMD 310_1, for example. These packages are also known as DPAKs.

SMD 310_2 is a conventional transistor package of Infineon^{®} referred to as PG-TO263-3-2. SMD 310_3 is a conventional transistor package of Infineon^{®} referred to as PG-TDSON-8-7. SMD 310_4 is a conventional transistor package of Infineon^{®} referred to as PG-VSON-4-1. All these packages are typical reflow packages, i.e. are conventionally soldered to an application board by reflow soldering.

Other SMD packages which are typical reflow packages but can be used for wave soldering in accordance with the disclosure are PG-TDSON-8-7 and PG-LHSOG-8-1 of Infineon^{®}.

SMD 310_1 is, e.g., a 3-terminal package. The length L of the encapsulation body 320 is L = 6.22 mm, the width W of the encapsulation body 320 is 6.5 mm. The length Lm of the footprint bottom metallization is Lm = 4.24 mm, and the width Wm of the bottom metallization 372 is Wm = 5 mm.

SMD 310_2 is, e.g., a 3-terminal package. The encapsulation body 320 has dimensions L = 10 mm and W = 9.25 mm. The dimensions of the bottom metallization 372 are Wm = 8.5 mm and Lm = 6.55 mm, with an extension Em = 1 mm protruding over the outline of the encapsulation body 320.

SMD 310_3 is, e.g., an 8-terminal package. The dimensions of the encapsulation body 320 are L = 5.9 mm and W = 5.15 mm. The dimensions of the bottom metallization 372 are Wm = 4.3 mm and Lm = 4.135 mm.

SMD 310_4 is, e.g., a 4-terminal package. The dimensions of the encapsulation body 320 are L = 8 mm and W = 8 mm. The dimensions of the bottom metallization 372 are Lm = 3.65 mm and Wm = 7.2 mm.

The bottom metallization 372 is also referred to as an "exposed paddle" in the art.

The aforementioned dimensions of the encapsulation body 320 and the (continuous) exposed bottom metallization 372 are example values for body size and metallization size, which can be generalized to all SMDs 310 configured to be mounted an application board 270. For example, the encapsulation body 320 may have lateral dimensions L and/or W equal to or greater than 4, 5, 6, 7, or 8 mm, for example. The bottom metallization 372 may have lateral dimensions Lm and/or Wm equal to or greater than 3, 4, 5, 6, 7, or 8 mm, for example.

In general, the disclosure includes leaded devices (e.g. SMDs 310_1, 310_2) and leadless devices (e.g. SMDs 310_3, 310_4). In leaded devices, the bottom metallization 372 as well as the leads 373, 374 have to be solder-bonded to the application board 270 by the soldering process (e.g., wave soldering). The SMDs may have a bottom metallization 372 which includes one or a plurality of terminals (i.e. the bottom metallization 372 may be shaped as one continuous metal pad (e.g. SMDs 310_1, 310_2) or may include a plurality of sections, e.g. a main section ("exposed paddle") and one or a plurality of further sections which are, e.g., typically arranged close to an edge of the encapsulation body 320 (e.g. SMDs 310_3, 310_4). In particular, the disclosure includes leadless devices referred to as bottom terminated component (BTC) such as, e.g., QFN (quad flat no lead) MLF (micro lead frame), DFN (dual flat no lead) devices, etc.

All SMDs 310, 310_1 to 310_4 may, e.g., be BSC (backside cooled) packages, i.e. packages in which the bottom side metallization 372 (exposed paddle) allows (e.g. in addition to its electrical terminal function) for high thermal conductivity to the application board 270. The disclosure further includes FSC (front side cooled) packages such as, e.g., the double DPAK (DDPAK) package.

Generally speaking, the sequence of processes S3, S4, S5 (Figure 1) allows control and adjustment of the height H to make wave soldering (or other soldering techniques which rely on introducing molten solder into the gap between the SMD and the application board) an available assembly technique for SMDs, especially SMDs with footprint metallization. The height H can be set individually for each package on an application board, depending, e.g., on their positions on the application board and/or the specifics of different SMD packages on the application board in terms of, e.g., dimensional quantities such as L, W, Lm, Wm, for example.

### EXAMPLES

The following examples pertain to further aspects of the disclosure:
Example 1 is a method of soldering a surface mount device, SMD, to an application board, the method comprising: depositing one or more first adhesive volumes onto the application board; hardening the one or more first adhesive volumes; depositing one or more second adhesive volumes onto the application board; placing the SMD on the hardened one or more first adhesive volumes in contact with the one or more second adhesive volumes, wherein the SMD is supported by the hardened one or more first adhesive volumes to form a gap between the application board and the SMD; hardening the one or more second adhesive volumes to hold the SMD to the application board; and soldering the SMD to the application board by applying molten solder in the gap between the application board and the SMD.
In Example 2, the subject matter of Example 1 can optionally include wherein soldering comprises wave soldering.
In Example 3, the subject matter of Example 1 or 2 can optionally include wherein the gap has a height of equal to or greater than 150 or 200 µm.
In Example 4, the subject matter of any of the preceding Examples can optionally include wherein at least four first adhesive volumes are deposited onto the application board at locations corresponding to at least four corners of the SMD.
In Example 5, the subject matter of any of the preceding Examples can optionally include wherein the at least one or more second adhesive volumes are deposited onto the application board at locations which are in average nearer to the center of the SMD than the locations at which the first adhesive volumes have been deposited.
In Example 6, the subject matter of any of the preceding Examples can optionally include wherein locations at which the one or more first adhesive volumes are deposited and locations at which the one or more second adhesive volumes are deposited are offset from each other.
In Example 7, the subject matter of any of the preceding Examples can optionally include wherein the one or more first adhesive volumes and the one or more second adhesive volumes are of the same adhesive and/or depositing the one or more first adhesive volumes and depositing the one or more second adhesive volumes are carried out by using the same adhesive dispensing equipment.
In Example 8, the subject matter of any of the preceding Examples can optionally include wherein the SMD comprises an encapsulation body having a bottom surface, wherein at least one metallization is exposed at the bottom surface.
Example 9 is a system comprising a surface mount device, SMD, and an application board to which the SMD is mounted. The system comprises one or more posts of hardened adhesive arranged between the application board and the SMD, wherein a gap is provide between the application board and the SMD; and a solder bond arranged at least partly within the gap between the application board and the SMD, wherein the gap has a height of equal to or greater than 150 or 200 µm.
In Example 10, the subject matter of Example 9 can optionally include wherein the SMD comprises an encapsulation body having a bottom surface, wherein at least one metallization is exposed at the bottom surface and the solder bond connects between a conductive land on the application board and the metallization.
In Example 11, the subject matter of Example 9 or 10 can optionally include wherein the one or more posts of hardened adhesive are arranged at least at four corners of the encapsulation body.
In Example 12, the subject matter of any of the Examples 9 to 11 can optionally include wherein the SMD is a power device.
In Example 13, the subject matter of any of the Examples 9 to 12 can optionally include wherein the encapsulation body has lateral dimensions equal to or greater than 4, 5, 6, 7, or 8 mm.
In Example 14, the subject matter of any of the Examples 9 to 13 can optionally include wherein the SMD is a leadless device.
In Example 15, the subject matter of any of the Examples 9 to 13 can optionally include wherein the SMD is a leaded device.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method of soldering a surface mount device, SMD, to an application board, the method comprising:
depositing one or more first adhesive volumes onto the application board;
hardening the one or more first adhesive volumes;
depositing one or more second adhesive volumes onto the application board;
placing the SMD on the hardened one or more first adhesive volumes in contact with the one or more second adhesive volumes, wherein the SMD is supported by the hardened one or more first adhesive volumes to form a gap between the application board and the SMD;
hardening the one or more second adhesive volumes to hold the SMD to the application board; and
soldering the SMD to the application board by applying molten solder in the gap between the application board and the SMD.

2. The method of claim 1, wherein soldering comprises wave soldering.

3. The method of claim 1 or 2, wherein the gap has a height of equal to or greater than 150 or 200 µm.

4. The method of any preceding claim, wherein at least four first adhesive volumes are deposited onto the application board at locations corresponding to at least four corners of the SMD.

5. The method of any preceding claim, wherein the at least one or more second adhesive volumes are deposited onto the application board at locations which are in average nearer to the center of the SMD than the locations at which the first adhesive volumes have been deposited.

6. The method of any preceding claim, wherein locations at which the one or more first adhesive volumes are deposited and locations at which the one or more second adhesive volumes are deposited are offset from each other.

7. The method of any preceding claim, wherein the one or more first adhesive volumes and the one or more second adhesive volumes are of the same adhesive and/or depositing the one or more first adhesive volumes and depositing the one or more second adhesive volumes are carried out by using the same adhesive dispensing equipment.

8. The method of any preceding claim, wherein the SMD comprises an encapsulation body having a bottom surface, wherein at least one metallization is exposed at the bottom surface.

9. A system comprising a surface mount device, SMD, and an application board to which the SMD is mounted, the system comprising:
one or more posts of hardened adhesive arranged between the application board and the SMD, wherein a gap is provide between the application board and the SMD; and
a solder bond arranged at least partly within the gap between the application board and the SMD, wherein the gap has a height of equal to or greater than 150 or 200 µm.

10. The system of claim 9, wherein the SMD comprises an encapsulation body having a bottom surface, wherein at least one metallization is exposed at the bottom surface and the solder bond connects between a conductive land on the application board and the metallization.

11. The system of claim 10, wherein the one or more posts of hardened adhesive are arranged at least at four corners of the encapsulation body.

12. The system of any of claims 9 to 11, wherein the SMD is a power device.

13. The system of any of claims 9 to 12, wherein the encapsulation body has lateral dimensions equal to or greater than 4, 5, 6, 7, or 8 mm.

14. The system of one of claims 9 to 13, wherein the SMD is a leadless device.

15. The system of one of claims 9 to 13, wherein the SMD is a leaded device.
